# EUROPEAN PATENT APPLICATION

(11) **EP 1 193 736 A1**
(43) Date of publication of application: **03.04.2002**
(21) Application number: 00121040.0
(22) Date of filing: 27.09.2000
(51) Int. Cl.: H01L 21/00, B62B 3/00

(54) **Vehicle for transporting a semiconductor device carrier to a semiconductor processing tool**

(71) Applicant: Infineon Technologies SC300 GmbH & Co. KG, 01099 Dresden (DE)
(72) Inventor: Lering, Michael, 91088 Bubenreuth (DE)
(74) Representative: Fischer, Volker, Dipl.-Ing.

(57) **Abstract**

A vehicle for transporting semiconductor devices is provided, that allows to serve the loadports (2) of semiconductor processing tools (1) with device carriers (5) like a portal hoist (4) from the top. Thereby, the vehicle comprises an empty inner space (10) and an open front side, such that the loadport (2) is enclosed by the vehicle, when it approaches and docks to the loadport (2). Time for loading is shortened, complexity of structure and procedure is reduced and cleanroom space is saved.

## Description

The present invention relates to a vehicle for transporting a semiconductor device carrier to a semiconductor processing tool.

In semiconductor device fabrication a commonly used transport means for semiconductor carriers containing semiconductor devices such as wafers is the so-called person guided vehicle (PGV). E.g., in the cleanroom area of wafer fabs, these vehicles are pushed manually by operators to transfer one or more wafer carriers from one processing tool to the next according to the wafer processing sequence.

The structure and form of person guided vehicles may vary considerably from fab to fab or even from bay to bay depending on the local requirements which have to be fulfilled, such as the type of the loadports of the processing tool, the number and size of the wafer carrier to be transferred or the dimension of the aisles and processing tools with loadports in the cleanroom area. With the advent of larger wafer sizes having diameters of 200 mm or 300 mm, filled wafer carriers have become too heavy to be handled manually. Instead, mechanical transfer means on top of the vehicles perform the task of placing or picking up the wafer carrier to and from the loadports of the processing tools, which are then operated manually.

Commonly used transfer means comprise lifter booms. In a corresponding loading step for instance, the vehicle is first required to dock to the processing tool having the destination loadport in order to achieve high placement precision. In this docking position the vehicle stands in front of the loadport with the device carrier located on top of the vehicle in front of the loadport. Then, the wafer carrier is taken and either turned or pushed to the loadport by the lifter boom. For this purpose the vehicle requires a structure such as to outweigh the eccentric weight of the wafer carrier, when the lifter boom is expanded, resulting in a larger total weight or size.

The footprint of equipment and the aisles in the cleanroom area are strong contributors to non-value added costs of wafer production. Therefore, the large sizes and the circumstantial position in front of the loadports requiring broad aisles increase wafer fabrication costs. A minimum width between two limiting sides of an aisle added by the size of two vehicles serving two opposite processing tools is necessary, in order to guarantee operators free paths to emergency exits, even if the aisles are crowded with vehicles.

Moreover, manual transfer or transfer with the lifter boom of the wafer carrier onto the loadport needs time of operating staff and may cause particle contamination due to vibration. Since vehicles have to deal with a variety of differently designed loadports, they usually lack an unique transfer handling, and are therefore not adapted to specific loadport designs such as the upcoming norm-compliant loadports.

It is therefore a primary objective of this invention to provide a vehicle for transporting semiconductor devices to a semiconductor processing tool, so that the amount of footprint needed is reduced thereby saving costs.

The objective is solved by a vehicle for transporting a semiconductor device carrier to a semiconductor processing tool, said tool having a loadport for a semiconductor device carrier attached to said semiconductor processing tool with a side length and a side depth and a height, said tool providing a free space above the loadport top surface, said load port being designed to receive the semiconductor device carrier, which can be loaded on top of the loadport surface and which is supplied with an interface for lifting, said vehicle comprising said chassis comprising a skeleton of support elements surrounding an inner space, which is left free of any support elements of the skeleton and can be freely accessed from the vehicle front side, said inner space having a length larger than the side length of said loadport, and said inner space having a depth larger than the side depth of said loadport, a set of wheels mounted on the chassis for moving the vehicle, a means for lifting mounted to the chassis of the vehicle within the vertical height range of the free space of said loadport, for placing or picking up said semiconductor device carrier, a vertically disposable lift connector means mounted to the means for lifting for connecting to said interface for lifting, and a crank mechanism mounted on said chassis for operating the means for lifting.

According to the present invention, a vehicle is provided, that significantly reduces the amount of footprint needed to load or unload a loadport of a processing tool in case the loadport is mounted to the processing tool in such a style, that the loadport structure can be enclosed by the vehicle during the loading step. For this purpose the vehicle comprises an inner space, that is free of any vehicle support structures, and an open front side, that allows any portrusion of the processing tool, i.e. the loadport and related supports beneath it, or service wheels, a free passage to that inner space, when the vehicle is approaching and docking to the processing tool.

Thus, instead of taking a docking and loading position in front of the load port, the load port is covered by the vehicle. The vehicle therefore has a location closer to the processing tool leaving more space on the aisles between the processing tools within the base.

The common regulations concerning the emergency exits requiring minimum widths of aisles inside the cleanroom area admit a denser layout of the processing tools inside the bay due to smaller aisles, if the requirements of the loadports according to this invention are followed within the bay and if only the vehicles according to the present invention are used. Thus, a considerable amount of costs can be saved due to the decreased footprint of vehicles and aisles in the expensive cleanroom area.

A further advantage arises from the construction of loading the loadport with the device carrier from the top. A means for lifting is mounted on the chassis of the vehicle carrying the device carrier, with the height of the bottom surface of the device carrier being in a higher position than the loadport surface. Although the opposite case, the device carrier having a level below the loadport surface, is not ruled out, the aforementioned position is to be preferred, because no additional lifting is needed when docking to the loadport.

In the docking position the device carrier hold by the means for the lifting is located in a free space above the loadport surface, while the loadport is enclosed by the vehicle located in the inner space of the vehicle. In order to load the loadport, the device carrier just has to be lifted down by the means for lifting onto the loadport surface. Therefore no horizontal motion is necessary and a high precision placement is easily implemented. Moreover, since there is no eccentric movement of the device carrier, the center of gravity of the vehicle when projected down to the floor is not significantly changed, thus simplifying the structure of supports of the vehicle reducing its weight and size.

The means for lifting is operated by a crank mechanism mounted on the chassis of the vehicle for lifting the device carrier in vertical direction. Since according to this invention there is only one axis of movement, the forces and vibration acting on the devices in the device carrier are advantageously reduced. The small amount of lifting path additionally saves time to load or unload the device carrier.

A further aspect considers a means for the docking to a load port. Having installed such a means, the vehicle will be in a fixed position enclosing the loadport, and the device carrier will be in a position directly above the loadport. An automatic precision placement of the device carrier onto the load port is therefore straightforwardly implemented.

Further advantages features, aspects and details of the invention are evident from the depended claims.

An embodiment of the invention is now described with reference to the drawings. In the drawings:
- Figure 1: (a) - (e) show different side views of a preferred embodiment of the vehicle according to this invention, including a top view (a), a front view (b), a side view (c), a back view (d) and a bottom view (e) .
- Figure 2: (a) and (b) demonstrate a determination of minimum with of aisles between processing tools within base according to prior art (a) and according to an embodiment of this invention in a top view.

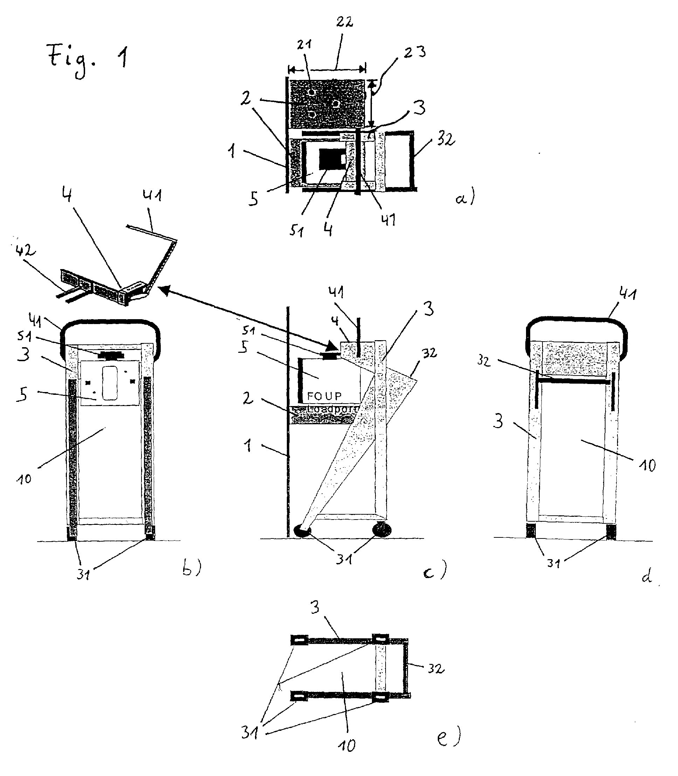

In an embodiment according to this invention a person guided vehicle is provided, that is suited to so-called balcony type loadports 2. Ideally, such a loadport 2 protudes orthogonally out of the front side of a processing tool 1. Preferably, the loadport is compliant with SEMI-norm E15.1. Processing tools having loadports according to this norm have become very common in the case of 300 mm production and metrology tools. A free space in front of the processing tool 1 above the loadport surface extending at least up to the height of the vehicle according to this embodiment guarantees, that a device carrier 5 can be carried into this space hold by a means for lifting 4 on top of the vehicle chassis 3, which can be seen in figure 1 (c). In this figure 1 a vehicle serving a loadport 2 is displayed.

As is evident from figure 1 (a) the device carrier 5 is carried directly above the load port, and just needs to be released in a vertical movement onto kinematical pins 21, which are suited to corresponding groves in the bottom plate of the device carrier 5, in order to achieve high precision placement. In this top view it is easliy recognized, that the vehicle footprint covers the loadport footprint, thus saving space, which had to be added in prior art.

Figure 1 (b) demonstrates, how an inner space 10 is embedded inside chassis 3. The inner space 10 is limited by the left and right side supports of chassis 3, by device carrier 5 hold beneath the means for lifting, and by the floor. Thereby the width of inner space 10 is larger than the side length 23 of loadport 2, and the depth of inner space 10 is larger than the side depths 22 of loadport 2. Thus, in a correct load position load port 2 does not obstruct with chassis 3.

According to this embodiment the device carrier 5 is a front opening unified pod (FOUP), with the advantage, that the individual device handling is performed by the processing tool 1, and the lifting path length for the means for lifting just needs to be about 1 cm, which becomes evident from figure 1 (c). The interface for lifting 51 of device carrier 5 of the means for lifting 4 has the form of a top mushroom, with a fork lift as the lift connector means 42 as a suitable counterpart for lifting up or down device carrier 5 but any other connecting means either hanging or sustaining can as well be utilised.

Having found the correct position to the loadport or having docked the vehicle, the operator 9 can manually operate the crank 41 in order to lift up or down the device carrier 5. Since the device carrier is lifted down to the loadport surface from the top and the means for lifting has it's support in the left and right side supports of chassis 3 the means for lifting 4 is essentially a portal hoist. According to this embodiment horizontal movements of the fork lift 42 on the portal hoist 4 are possible as well in order to improve placement characteristics.

Comparing figures 1 (c) and 1 (d) the use of a main diagonal support as a means for pushing the vehicle 32 can be seen. Operating the crank 41 and the means for pushing the vehicle 32 both from the back side of the vehicle, without the need to turn around the vehicle, simplifies the process of raising or releasing the device carrier 5 significantly. Moreover, the use of fixed axis wheels as front wheels 31 is possible, while the back wheels 31 being rotable about the vertical axis are used to manoeuvre the vehicle. Thus, the time of the loading procedure can be minimized, and the complexity of the structure is still reduced.

A bottom view protection of chassis 3 is shown in figure 1 (e). It can be seen, that chassis 3 simply has the form of a 'U'. Thus, even if there are portrusions beneath the load port 2, such as service wheels, they would be located inside inner space 10, if the vehicle is in load position, and would therefore not obstruct with the vehicle.

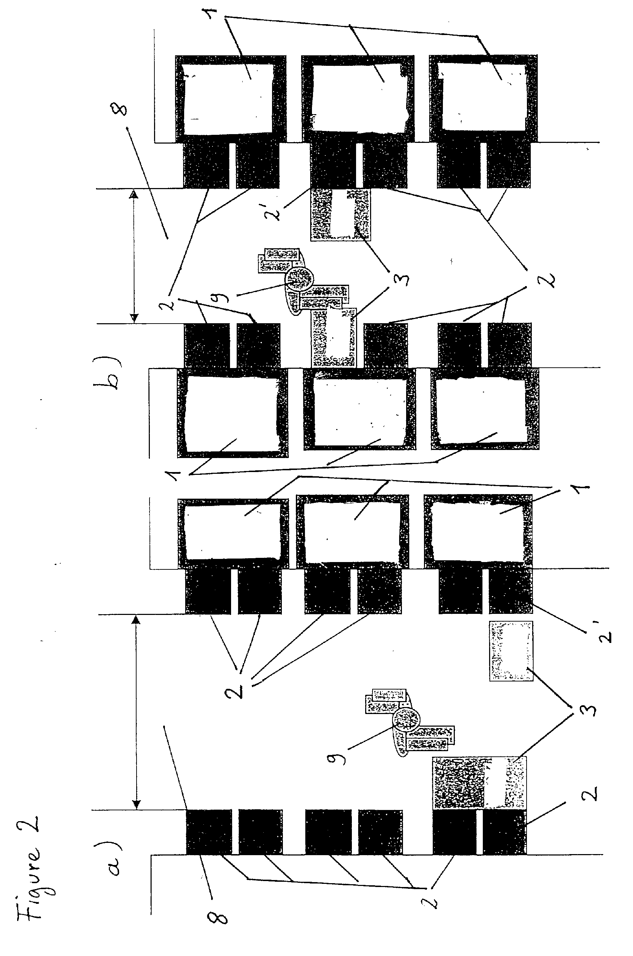

The amount of space saved in the cleanroom area according to the embodiment of this invention becomes evident from comparison of figures 2 (a) and (b). Several processing tools 1 each having two loadports 2 enclosing an aisle 8 are shown. In order to adhere to the regulations for emergency cases, there must be enough space for an operator 9 in the aisle 8 to pass through the vehicles standing opposite to each other, one of them serving one of the loadports 2, the other just standing in front of the opposite loadport 2'. In the prior art case a typical width of aisles 8 has been 2.200 mm, which may be observed in figure 2 (a), while according to the embodiment of this invention the width reduces to 1.600 mm, because the footprint of the vehicle can be laid over the footprint of a load port, which can be seen in figure 2 (b). Using a typical number of loadports 2 and processing tools 1 in a fab, 250 m² of space can be saved with an cost equivalent of about 5.000.000 Euro.

## Claims

1. Vehicle for transporting a semiconductor device carrier to a semiconductor processing tool (1),
(a) said tool having a loadport (2) for a semiconductor device carrier (5) attached to said semiconductor processing tool (1) with a side lenght (23) and a side depth (22) and a height, said tool providing a free space above the loadport top surface, and
(b) said loadport being designed to receive the semiconductor device carrier (5), which can be loaded on top of the loadport surface and which is supplied with an interface for lifting (51),
(c) said vehicle comprising
- a chassis (3) comprising a skeleton of support elements surrounding an inner space (10), which is left free of any support elements of the skeleton and can be freely accessed from the vehicle front side, said inner space (10) having a length larger than the side length (23) of said loadport, and said inner space (10) having a depth larger than the side depth (22) of said loadport,
- a set of wheels (31) mounted to the chassis (3) for moving the vehicle,
- a means for lifting (4) mounted to the chassis (3) of the vehicle within the vertical height range of the free space of said loadport, for placing or picking up said semiconductor device carrier (5),
- a vertically disposable lift connector means (42) mounted to the means for lifting (4) for connecting to said interface for lifting (51) of the device carrier (5),
- a crank mechanism (41) mounted on said chassis (3) for operating the means for lifting (4).

2. Vehicle according to claim 1,
**characterised by**
comprising a means for docking to said loadport, such that the means for lifting (4) carrying a semiconductor device carrier (5) reaches a position directly above the loadport (2).

3. Vehicle according to claim 1 or 2,
**characterised in that**
the lift connector means (42) is a fork lift, and the interface for lifting (51) has the form of a mushroom.

4. Vehicle according to anyone of claims 1 to 3,
**characterised in that**
the semiconductor device carrier (5) is a front opening unified pod carrying at least one semiconductor wafer of a diameter of at least 300 millimeters.

5. Vehicle according to anyone of claims 1 to 4,
**characterised in that**
the chassis (3) is U-shaped.

6. Vehicle according to anyone of claims 1 to 5,
**characterised in that**
the vehicle comprises a means to push the vehicle (32) manually by an operator.

7. Vehicle according to anyone of claims 1 to 6,
**characterised in that**
said means for lifting (4) is a portal hoist.
